# EUROPEAN PATENT APPLICATION

(11) **EP 2 112 725 A1**
(43) Date of publication of application: **28.10.2009**
(21) Application number: 08783795.1
(22) Date of filing: 29.07.2008
(51) Int. Cl.: H01S 3/00, H04B 10/02, H04J 14/00

(54) **AN OPTICAL MODULATION SYSTEM AND METHOD**

(30) Priority: 23.11.2007 CN 200710188086
(71) Applicant: Huawei Technologies Co., Ltd., Longgang District Shenzhen Guangdong 518219 (CN)
(72) Inventor: WANG, Guozhong, Shenzhen Guangdong 518129 (CN)
(74) Representative: Epping - Hermann - Fischer
(86) International application number: PCT/CN2008/071802
(87) International publication number: WO 2009/065314

(57) **Abstract**

The present invention relates to optical communication, and discloses an optical modulation system and an optical modulation method. The system includes: a light emitting apparatus, a wavelength sensor, a signal processor, a controller, a pulse modulation driver, an amplitude modulation driver, and an amplitude modulator. The method includes: receiving a second optical signal among optical signals generated by a light emitting apparatus, and outputting intermittent optical signals of stable wavelengths under modulation of an amplitude drive signal, where: the optical signals are generated by the light emitting apparatus under control of a wavelength control signal and have stable wavelengths, and the wavelength control signal is generated by calculating a first optical signal emitted by the light emitting apparatus. Through the system and the method under the present invention, the laser emits light continuously in the intervals of transmitting optical pulses; the laser outputs optical signals of stable wavelengths by feeding back and controlling the working parameters of the laser; and the external amplitude modulator ensures the high-resistance state in the intervals of transmitting optical pulses, thus outputting intermittent optical pulse signals of stable wavelengths and meeting the monitoring requirements of the optical cable system and the marine cable system such as OTDR.

## Description

### FIELD OF THE INVENTION

The present invention relates to optical communication, and in particular, to an optical modulation system and an optical modulation method.

### BACKGROUND

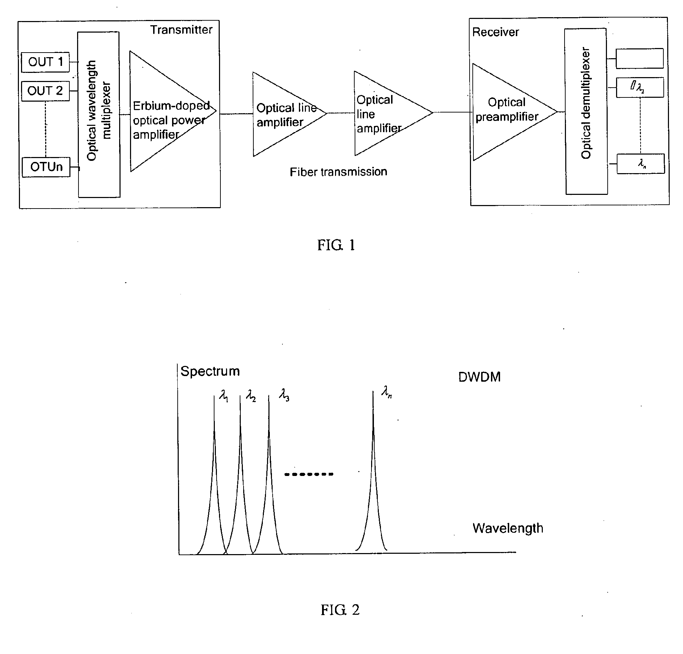

With rapid development of technologies, much more information needs to be transmitted in the communication field. In the optical communication field, the operators and equipment manufacturers pay more and more attention to the Dense Wavelength Division Multiplex (DWDM) technology. The DWDM technology makes use of the bandwidth of the single-mode fibers and the low-loss feature of such fibers, uses multiple wavelengths as carriers, and allows all the carrier channels to transmit information in the fiber simultaneously. FIG. 1 shows a structure of a DWDM system in the prior art. In this system, the optical transmitter transmits optical signals which have different wavelengths but have precision and stability compliant with certain requirements to multiple Optical Transport Units (OTUs). The wavelengths of the optical signals are λ₁, λ₂... λ*ₙ*. The optical signals are sent to an optical wavelength multiplexer. After being multiplexed together by the optical wavelength multiplexer, the optical signals are sent to Erbium-doped optical power amplifier to make up for the optical signal power loss caused by the optical wavelength multiplexer and boost the transmitting power of the optical signals. After being boosted by the Erbium-doped optical power amplifier, the optical signals are sent to the fiber for transmission (an optical line amplifier may be configured in the fiber transmission as specifically required). For example, supposing that the wavelengths of the optical signals are λ₁, λ₂... λ*ₙ*, the carrier signals of the optical signals may be transmitted in the fiber simultaneously. FIG. 2 shows a spectrum of optical signal transmission in a DWDM system. The optical signals are transmitted through the fiber to the receiver. An optical preamplifier amplifies the received optical signals to improve the receiving sensitivity of the optical signals and prolong the transmission distance. The amplified optical signals are sent to an optical demultiplexer. The optical demultiplexer demultiplexes the optical signals whose wavelengths are λ₁, λ₂ ... λ*ₙ* respectively.

The working wavelengths of the DWDM system are dense. The intervals between the working wavelengths are measured in nanometers. Therefore, the laser that generates signals in the optical transmitter needs to be capable of generating the working wavelengths compliant with the criteria of the DWDM system, and the working wavelengths need to be highly stable. In a DWDM system, the common Distributed Feed Back (DFB) lasers control the wavelength stability by controlling the temperature of the laser mandrel in view of the feature of corresponding relationship between the wavelength and the mandrel temperature. For example, for a 1.5 µm DFB laser, the wavelength temperature coefficient is about 0.02 nm/°C, and the wavelengths generated within the 15°C-35°C range meet the requirements. However, such a temperature feedback control method absolutely depends on the mandrel temperature of the DFB laser, and is unable to solve long-term wavelength change caused by laser aging.

### SUMMARY

A system and a method of optical modulation are disclosed in an embodiment of the present invention to generate intermittent optical signals of stable wavelengths. The embodiments of the present invention are implemented through the following technical solution:

An optical modulation system is disclosed herein. The system includes:
a light emitting apparatus 301, adapted to generate optical signals;
a wavelength sensor 302, adapted to: receive a first optical signal among the optical signals generated by the light emitting apparatus 301, and report the wavelength value of the first optical signal;
a signal processor 303, adapted to: receive the wavelength value reported by the wavelength sensor 302, calculate the deviation between the wavelength value and the preset wavelength value, generate a wavelength control signal according to the deviation, and send the wavelength control signal;
a controller 304, adapted to: receive the wavelength control signal from the signal processor 303, and adjust the working parameters of the light emitting apparatus 301 according to the wavelength control signal;
an amplitude modulation driver 306, adapted to generate and send an amplitude drive signal; and
an amplitude modulator 307, adapted to: receive a second optical signal generated by the light emitting apparatus 301 and the amplitude drive signal sent by the amplitude modulation driver 306, modulate the second optical signal according to the amplitude drive signal, and output intermittent optical signals of stable wavelengths.

An optical modulation method is disclosed herein. The method includes:
receiving the second optical signal among the optical signals generated by the light emitting apparatus, and output intermittent optical signals of stable wavelengths under modulation of the amplitude drive signal, where: the optical signals are generated by the light emitting apparatus under control of the wavelength control signal and have stable wavelengths, and the wavelength control signal is generated by calculating the first optical signal emitted by the light emitting apparatus. The technical solution under the present invention brings the following benefits:

Through integrated work of the components such as pulse modulation drive and amplitude modulation drive, the light emitting apparatus under the present invention generates intermittent optical signals of stable wavelengths or intermittent optical pulse signals of stable wavelengths. The generated signals meet the requirements imposed on the signals transmitted by the transmitter in the detection systems such as Optical Time Domain Reflectometer (OTDR), and meet the application requirements imposed by the monitoring systems deployed through optical cables and marine cables.

### BRIEF DESCRIPTION OF THE DRAWINGS

FIG. 1 shows a structure of a DWDM system in the prior art;

FIG. 2 shows a spectrum of a DWDM system in the prior art;

FIG. 3 is a schematic diagram of an optical modulation system according to an embodiment of the present invention;

FIG. 4 is another schematic diagram of an optical modulation system according to an embodiment of the present invention;

FIG. 5 shows an optical modulation system according to a first embodiment of the present invention;

FIG. 6 shows an optical modulation system according to a second embodiment of the present invention;

FIG. 7 shows an optical modulation system according to a third embodiment of the present invention;

FIG. 8 is a flowchart of an optical modulation method according to a fourth embodiment of the present invention;

FIG. 9 shows a working time sequence of the method according to the fourth embodiment of the present invention; and

FIG. 10 is a flowchart of an optical modulation method according to a fifth embodiment of the present invention.

### DETAILED DESCRIPTION

In order to make the technical solution, objectives and merits of the present invention clearer, the embodiments of the present invention are described below in detail by reference to accompanying drawings.

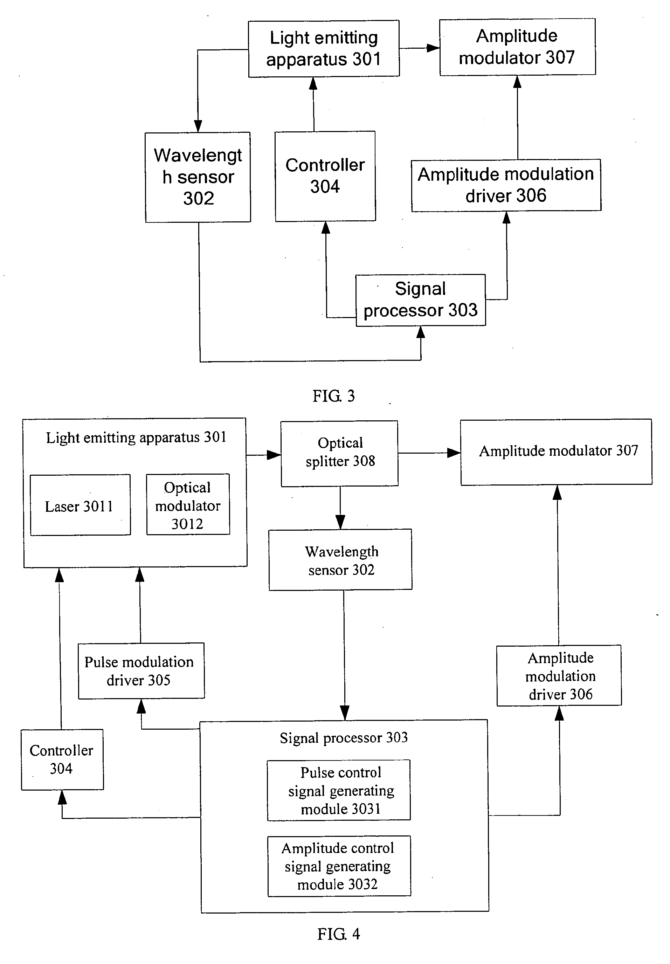

An optical modulation system is disclosed in an embodiment of the present invention to generate intermittent optical signals of stable wavelengths and meet the requirements of detection systems such as OTDR. As shown in FIG. 3, the system includes:
a light emitting apparatus 301, adapted to generate optical signals;
a wavelength sensor 302, adapted to: receive a first optical signal among the optical signals generated by the light emitting apparatus 301, and report the wavelength value of the first optical signal;
a signal processor 303, adapted to: receive the wavelength value reported by the wavelength sensor 302, calculate the deviation between the wavelength value and the preset wavelength value, generate a wavelength control signal according to the deviation, and send the wavelength control signal;
a controller 304, adapted to: receive the wavelength control signal from the signal processor 303, and adjust the working parameters of the light emitting apparatus 301 according to the wavelength control signal;
an amplitude modulation driver 306, adapted to generate and send an amplitude drive signal; and
an amplitude modulator 307, adapted to: receive a second optical signal generated by the light emitting apparatus 301 and the amplitude drive signal sent by the amplitude modulation driver 306, modulate the second optical signal according to the amplitude drive signal, and output intermittent optical signals of stable wavelengths.

As shown in FIG 4, in the technical solution under the present invention, the optical modulation system further includes:
an optical splitter 308, adapted to split the optical signal generated by the light emitting apparatus 301;
a wavelength sensor 302, adapted to: receive a first optical signal as a result of splitting by the optical splitter 308, and report the wavelength value of the first optical signal to the signal processor 303; and
an amplitude modulator 307, adapted to: receive a second optical signal as a result of splitting by the optical splitter 308 and the amplitude drive signal sent by the amplitude modulation driver 306, modulate the second optical signal according to the amplitude drive signal, and output intermittent optical signals of stable wavelengths.

The first optical signal received by the wavelength sensor 302 from the light emitting apparatus 301 is a backlight signal generated by the light emitting apparatus.

Accordingly, the second optical signal received by the amplitude modulator 307 from the light emitting apparatus 301 is a non-backlight signal generated by the light emitting apparatus.

As shown in FIG. 4, the system disclosed in this embodiment further includes:
a pulse modulation driver 305, adapted to: generate a pulse drive signal, and drive the light emitting apparatus 301 with the pulse drive signal.

The light emitting apparatus 301 generates optical pulse signals as driven by the pulse modulation driver 305.

The light emitting apparatus 301 includes: a laser 3011 and an optical modulator 3012. The laser 3011 is adapted to generate optical signals.

The controller 304 is adapted to receive the wavelength control signal from the signal processor 303, and adjust the working parameters of the laser 3011 according to the wavelength control signal.

The pulse modulation driver 305 is adapted to generate a pulse drive signal, and drive the optical modulator 3012 with the pulse drive signal.

The optical modulator 3012 is adapted to receive a pulse drive signal, modulate the laser 3011 to generate an optical signal according to the pulse drive signal, and output the optical pulse signal.

The optical modulator 3012 is: an acousto-optic modulator, an electroabsorption modulator, or a waveguide modulator.

The signal processor 303 further includes a pulse control signal generating module 3031, which is adapted to generate a pulse control signal, and send the pulse control signal to the pulse modulation driver 305. Accordingly, the pulse modulation driver 305 is adapted to generate a pulse drive signal according to the pulse control signal sent by the pulse control signal generating module 3031.

The signal processor 303 further includes an amplitude control signal generating module 3032, which is adapted to generate an amplitude control signal, and send the amplitude control signal to the amplitude modulation driver 306. Accordingly, the amplitude modulation driver 306 is adapted to generate an amplitude drive signal according to the amplitude control signal sent by the amplitude control signal generating module 3032, and send the amplitude drive signal to the amplitude modulator 307.

The amplitude modulator 307 is an acousto-optic modulator or an electrically variable attenuator.

In view of the modulation mode, the design of the optical modulation system is described below through three embodiments.

### Embodiment 1

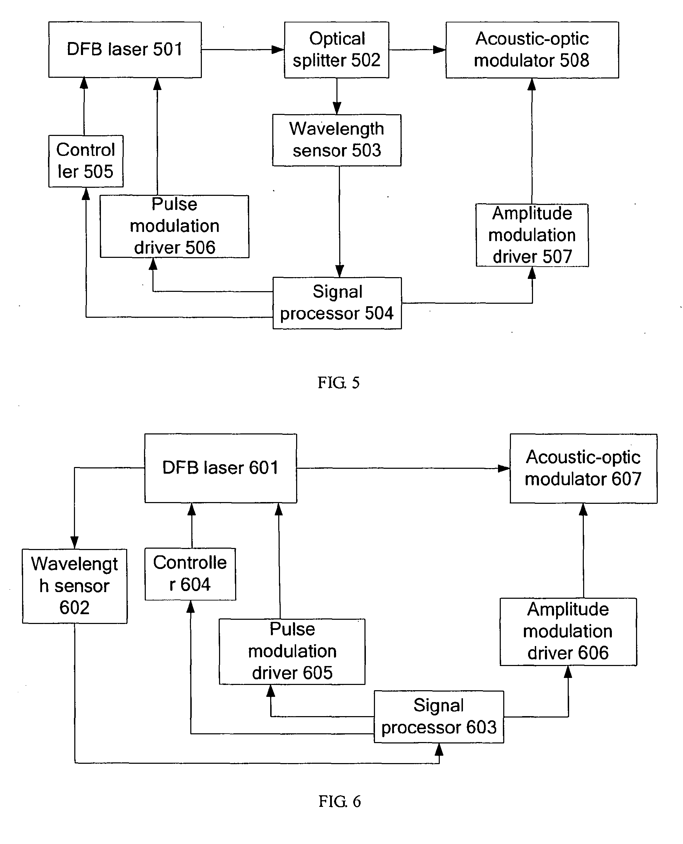

An optical modulation system is disclosed in this embodiment. In this system, the optical splitter splits the optical signal generated by the light emitting apparatus into two parts. One part is used to control stable wavelengths, and output intermittent optical pulse signals of stable wavelengths. It is assumed here that the light emitting apparatus is a DFB laser, and the amplitude modulator is an acousto-optic modulator. As shown in FIG. 5, the system includes: a DFB laser 501, an optical splitter 502, a wavelength sensor 503, a signal processor 504, a controller 505, a pulse modulation driver 506, an amplitude modulation driver 507, and an acoustic-optic modulator 508.

The DFB laser 501 is adapted to generate optical pulse signals.

The optical splitter 502 is adapted to: receive an optical pulse signal from the DFB laser 501, split the optical pulse signal received from the DFB laser 501 into two parts, send one part of the optical pulse signal to the wavelength sensor 503, and send the other part of the optical pulse signal to the acousto-optic modulator 508.

One part of the optical pulse signal may be defined as the first optical pulse signal. The other part of the optical pulse signal may be defined as the second optical pulse signal.

For example, the optical splitter 502 receives an optical pulse signal from the DFB laser 501, extracts 1% strength of the optical pulse signal and sends it to the wavelength sensor 503, and sends 99% strength of the optical pulse signal to the acousto-optic modulator 508, where the 1% strength of the optical pulse signal is the first optical pulse signal and the 99% strength of the optical pulse signal is the second optical pulse signal.

The wavelength sensor 503 is adapted to: receive one part of the optical pulse signal of the DFB laser 501 as a result of splitting by the optical splitter 502, and report the wavelength value of this part of optical pulse signal to the signal processor 504.

The signal processor 504 is adapted to: receive the wavelength value of a part of the optical pulse signal reported by the wavelength sensor 503, calculate the deviation between the wavelength value and the preset wavelength value, and judge whether the deviation falls within the preset deviation value range; if the deviation falls within the preset deviation value range, perform no operation because the system requirements are fulfilled; otherwise, generate a wavelength control signal according to the deviation value, and send the wavelength control signal to the controller 505.

The signal processor 504 is further adapted to: generate a pulse control signal, and send the pulse control signal to the pulse modulation driver 506; generate an amplitude control signal, and send the amplitude control signal to the amplitude modulation driver 507.

The controller 505 is adapted to: receive the wavelength control signal generated by the signal processor 504, control the working parameters of the DFB laser 501 according to the wavelength control signal, and ensure that the wavelengths of the optical pulse signals output by the DFB laser 501 keep steady within a specific range.

The working parameters of the DFB laser 501 may be: temperature, cavity length of the DFB laser 501, and so on.

The pulse modulation driver 506 is adapted to: receive the pulse control signal generated by the signal processor 504, generate a pulse drive signal and send the pulse drive signal to the DFB laser 501, and drive the DFB laser 501 to generate an optical pulse signal that matches the pulse control signal.

The amplitude modulation driver 507 is adapted to: receive the amplitude control signal generated by the signal processor, generate an amplitude drive signal and send the amplitude drive signal to the acoustic-optic modulator 508, and drive the acoustic-optic modulator 508 to adjust insertion loss corresponding to the amplitude control signal.

The signal processor 504 further includes a pulse control signal generating module, which is adapted to generate a pulse control signal, and send the pulse control signal to the pulse modulation driver 506. Accordingly, the pulse modulation driver 506 is adapted to generate a pulse drive signal according to the pulse control signal sent by the pulse control signal generating module. The signal processor 504 further includes an amplitude control signal generating module. The amplitude control signal generating module is adapted to: generate an amplitude control signal, and send the amplitude control signal to the amplitude modulation driver 507. Accordingly, the amplitude modulation driver 507 is adapted to: generate an amplitude drive signal according to the amplitude control signal sent by the amplitude control signal generating module, and send the amplitude drive signal to the amplitude modulator.

The pulse modulation driver 506 and the amplitude modulation driver 507 serve the purpose of a signal amplifier in practice. The pulse modulation driver 506 is adapted to amplify the strength of the received pulse control signal to obtain a pulse drive signal capable of driving the DFB laser 501. The amplitude modulation driver 507 is adapted to amplify the strength of the received amplitude control signal to obtain an amplitude drive signal capable of driving the acoustic-optic modulator 508.

The acoustic-optic modulator 508 is adapted to: receive the other part of the optical pulse signal of the DFB laser 501 as a result of splitting by the optical splitter 502, receive the amplitude drive signal sent by the amplitude modulation driver 507, control the insertion loss of the acoustic-optic modulator according to the amplitude drive signal, and generate intermittent optical pulse signals of stable wavelengths.

Further, if a constant optical signal generated by the DFB laser 501 needs to be driven, the pulse control signal is a constant signal, for example, a constant current signal; if an optical pulse signal generated by the DFB laser 501 needs to be driven, the pulse control signal is a pulse signal, for example, a single pulse current signal or pulse sequence current signal.

For example, when the acoustic-optic modulator 508 needs to output the received optical signal, the amplitude control signal sent by the signal processor 504 is a low-resistance control signal. After receiving the low-resistance control signal, the amplitude modulation driver 507 drives the acoustic-optic modulator 508 to adjust the insertion loss to a low-resistance state. When the acoustic-optic modulator 508 does not need to output the received optical signal, the amplitude control signal sent by the signal processor 504 is a high-resistance control signal. After receiving the high-resistance control signal, the amplitude modulation driver 507 drives the acoustic-optic modulator 508 to adjust the insertion loss to a high-resistance state. The extinction ratio of the acoustic-optic modulator 508 is very high (generally greater than 40 dB). Therefore, when the insertion loss of the acoustic-optic modulator 508 is in the high-resistance state, the optical signal leaked from the acoustic-optic modulator 508 is very weak, and fulfills the OTDR working requirements.

In the foregoing embodiment, the DFB laser 501, optical splitter 502, wavelength sensor 503, signal processor 504, and controller 505 work together to control stable wavelengths of the optical signals output by the DFB laser 501.

The system disclosed herein is able to control the DFB laser 501 to output optical signals of stable wavelengths. By driving the acoustic-optic modulator 508 to adjust the insertion loss to be in the high-resistance or low-resistance state, the system finally outputs intermittent optical signals of stable wavelengths. In the case of driving the DFB laser 501 to generate optical pulse signals, the system finally outputs intermittent optical pulse signals of stable wavelengths by driving the acoustic-optic modulator 508 to adjust the insertion loss to be in the high-resistance or low-resistance state.

Further, the acoustic-optic modulator 508 disclosed in this embodiment may be an electrically variable attenuator or another amplitude modulator.

The optical modulation system disclosed in this embodiment controls stable wavelengths by using a part of the optical pulse signal of the DFB laser 501 as a result of splitting by the optical splitter 502, and finally generates intermittent optical pulse signals of stable wavelengths under collaborative work of the components such as pulse modulation driver 506 and amplitude modulation driver 507. The generated signals meet the requirements imposed on the signals transmitted by the transmitter in the detection systems such as OTDR, and meet the application requirements imposed by the monitoring systems deployed through optical cables and marine cables.

### Embodiment 2

An optical modulation system is disclosed in this embodiment. The system makes use of the features of the DFB laser, uses the backlight signal of the laser to control stable wavelengths, and finally outputs intermittent optical pulse signals of stable wavelengths. In this embodiment, it is assumed that the light emitting apparatus is a DFB laser, and the amplitude modulator is an acoustic-optic modulator. As shown in FIG. 6, the system includes: a DFB laser 601, a wavelength sensor 602, a signal processor 603, a controller 604, a pulse modulation driver 605, an amplitude modulation driver 606, and an acoustic-optic modulator 607.

The DFB laser 601 is adapted to generate optical pulse signals. Due to the features of the DFB laser 601, the generated optical pulse signals may be divided into backlight signals and non-backlight signals. The backlight signals are sent to the wavelength sensor 602 and the non-backlight signals are sent to the acoustic-optic modulator 607.

For example, in the strength of the optical signal emitted by the DFB laser 601, due to the features of the DFB laser 601, the 99% optical strength is used for generating non-backlight signals and the 1% optical strength is used for generating backlight signals. The wavelength of a backlight signal is the same as the wavelength of a non-backlight signal.

The backlight signal is also known as a first optical pulse signal, and the non-backlight signal is also known as a second optical pulse signal.

The wavelength sensor 602 is adapted to receive a backlight signal and report the wavelength value of the backlight signal to the signal processor 603.

The signal processor 603 is adapted to: receive the wavelength value of the backlight signal reported by the wavelength sensor 602, calculate the deviation between the wavelength value and the preset wavelength value, and judge whether the deviation falls within the preset deviation value range; if the deviation falls within the preset deviation value range, perform no operation because the system requirements are fulfilled; otherwise, generate a wavelength control signal according to the deviation value, and send the wavelength control signal to the controller 604.

The signal processor 603 is further adapted to: generate a pulse control signal, and send the pulse control signal to the pulse modulation driver 605; and generate an amplitude control signal, and send the amplitude control signal to the amplitude modulation driver 606.

The controller 604 is adapted to: receive the wavelength control signal generated by the signal processor 603, adjust the working parameters of the DFB laser 601 according to the wavelength control signal, and ensure that the wavelengths of the optical pulse signals output by the DFB laser 601 keep steady within a specific range.

The pulse modulation driver 605 is adapted to: receive the pulse control signal generated by the signal processor 603, generate a pulse drive signal and send the pulse drive signal to the DFB laser 601, and drive the DFB laser 601 to generate an optical pulse signal that matches the pulse control signal.

The amplitude modulation driver 606 is adapted to: receive the amplitude control signal generated by the signal processor, generate an amplitude drive signal and send the amplitude drive signal to the acoustic-optic modulator 607, and drive the acoustic-optic modulator 607 to adjust insertion loss corresponding to the amplitude control signal.

The acoustic-optic modulator 607 is adapted to: receive the non-backlight signal and the amplitude drive signal sent by the amplitude modulation driver 606, control the insertion loss of the acoustic-optic modulator according to the amplitude drive signal, and finally generate intermittent optical pulse signals of stable wavelengths.

In the foregoing embodiment, the DFB laser 601, wavelength sensor 602, signal processor 603, and controller 604 work together to control stable wavelengths of the optical signals output by the DFB laser 601.

The system disclosed herein is able to control the DFB laser 601 to output optical signals of stable wavelengths. By driving the acoustic-optic modulator 607 to adjust the insertion loss to be in the high-resistance or low-resistance state, the system finally outputs intermittent optical signals of stable wavelengths. In the case of driving the DFB laser 601 to generate optical pulse signals, the system finally outputs intermittent optical pulse signals of stable wavelengths by driving the acoustic-optic modulator 607 to adjust the insertion loss to be in the high-resistance or low-resistance state.

The acoustic-optic modulator 607 disclosed in this embodiment may be an electrically variable attenuator or another amplitude modulator.

The optical modulation system disclosed in this embodiment controls stable wavelengths by using the backlight signal of the DFB laser 601, and finally generates intermittent optical pulse signals of stable wavelengths under collaborative work of the components such as pulse modulation driver 606 and amplitude modulation driver 507. The generated signals meet the requirements imposed on the signals transmitted by the transmitter in the detection systems such as OTDR, and meet the application requirements imposed by the monitoring systems deployed through optical cables and marine cables.

### Embodiment 3

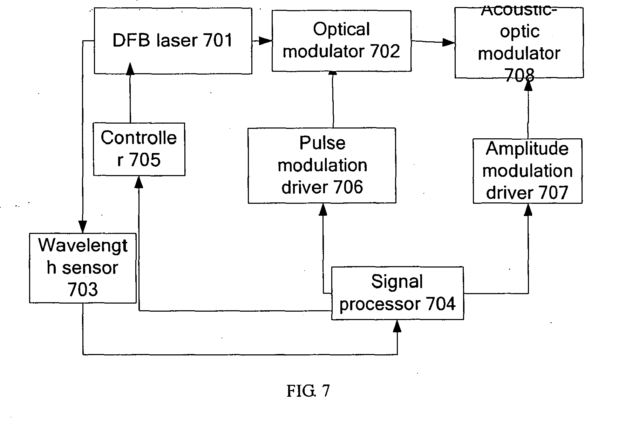

An optical modulation system is disclosed in this embodiment. This system makes use of the features of the DFB laser 701, uses the backlight signal of the laser to control stable wavelengths, and finally outputs intermittent optical pulse signals of stable wavelengths through external modulation for the laser. The light emitting apparatus includes a DFB laser 701 and an optical modulator 702. It is assumed that the amplitude modulator is an acousto-optic modulator. As shown in FIG. 7, the system includes: a DFB laser 701, an optical modulator 702, a wavelength sensor 703, a signal processor 704, a controller 705, a pulse modulation driver 706, an amplitude modulation driver 707, and an acoustic-optic modulator 708.

The DFB laser 701 is adapted to generate optical pulse signals. Due to the features of the DFB laser 701, the generated optical signals may be divided into backlight signals and non-backlight signals. The backlight signals are sent to the wavelength sensor 703 and the non-backlight signals are sent to the optical modulator.

The wavelength sensor 703 is adapted to receive a backlight signal and report the wavelength value of the backlight signal to the signal processor 704.

The signal processor 704 is adapted to: receive the wavelength value of the backlight signal reported by the wavelength sensor 703, calculate the deviation between the wavelength value and the preset wavelength value, and judge whether the deviation falls within the preset deviation value range; if the deviation falls within the preset deviation value range, perform no operation because the system requirements are fulfilled; otherwise, generate a wavelength control signal according to the deviation value, and send the wavelength control signal to the controller 705.

The signal processor 704 is further adapted to: generate a pulse control signal, and send the pulse control signal to the pulse modulation driver 706; generate an amplitude control signal, and send the amplitude control signal to the amplitude modulation driver 707.

The controller 705 is adapted to: receive the wavelength control signal generated by the signal processor 704, adjust the working parameters of the DFB laser 701 according to the wavelength control signal, and ensure that the wavelengths of the optical signals output by the DFB laser 701 keep steady within a specific range.

The pulse modulation driver 706 is adapted to: receive the pulse control signal generated by the signal processor 704, generate a pulse drive signal and send the pulse drive signal to the optical modulator, and drive the optical modulator to modulate the received non-backlight signal to an optical signal that matches the pulse control signal.

The optical modulator is adapted to: receive the non-backlight signal generated by the DFB laser 701 and the pulse drive signal generated by the pulse modulation driver 706, modulate the non-backlight signal to an optical pulse signal according to the pulse drive signal, and send the optical pulse signal.

The amplitude modulation driver 707 is adapted to: receive the amplitude control signal generated by the signal processor 704, generate an amplitude drive signal and send the amplitude drive signal to the acoustic-optic modulator 708, and drive the acoustic-optic modulator 708 to adjust insertion loss corresponding to the amplitude control signal.

The acoustic-optic modulator 708 is adapted to: receive the optical pulse signal sent by the optical modulator and the amplitude drive signal sent by the amplitude modulation driver 707, control the insertion loss of the acoustic-optic modulator according to the amplitude drive signal, and generate intermittent optical pulse signals of stable wavelengths.

In the foregoing embodiment, the DFB laser 701, wavelength sensor 703, signal processor 704, and controller 705 work together to control stable wavelengths of the optical signals output by the DFB laser 701.

The system disclosed in this embodiment is able to modulate the optical signals generated by the DFB laser 701 to optical pulse signals of stable wavelengths. By driving the acoustic-optic modulator 708 to adjust the insertion loss to be in the high-resistance or low-resistance state, the system finally outputs intermittent optical pulse signals of stable wavelengths. The system is also able to modulate the optical signals generated by the DFB laser 701 to optical signals of stable wavelengths. By driving the acoustic-optic modulator 708 to adjust the insertion loss to be in the high-resistance or low-resistance state, the system finally outputs intermittent optical signals of stable wavelengths.

The system disclosed in this embodiment may further include an optical splitter, which is adapted to split the optical signal received from the laser. Accordingly, the backlight signal received by the wavelength sensor 703 in this embodiment may also be a part of the optical signal generated by the DFB laser 701 and split by the optical splitter.

The optical modulator in this embodiment may be an acousto-optic modulator 708, an electro absorption modulator, or a waveguide modulator.

The acoustic-optic modulator 708 disclosed in this embodiment may be an electrically variable attenuator or another amplitude modulator.

The optical modulation system disclosed in this embodiment controls stable wavelengths by using the backlight signal of the DFB laser 701, generates optical signals of stable wavelengths, and generates intermittent optical pulse signals of stable wavelengths under collaborative work of the components such as optical modulator, pulse modulation driver 706 and amplitude modulation driver 707. The generated signals meet the requirements imposed on the signals transmitted by the transmitter in the detection systems such as OTDR, and meet the application requirements imposed by the monitoring systems deployed through optical cables and marine cables.

### Embodiment 4

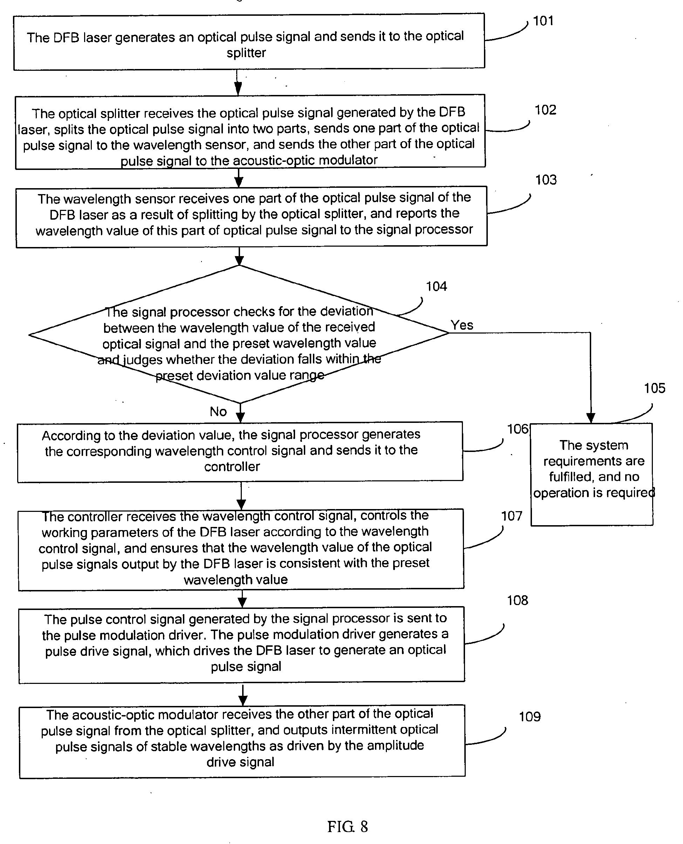

As shown in FIG. 8, an optical modulation method is disclosed in this embodiment. The method includes:
receiving the second optical signal among the optical signals generated by the light emitting apparatus, and outputting intermittent optical signals of stable wavelengths under modulation of the amplitude drive signal, where: the optical signals are generated by the light emitting apparatus under control of the wavelength control signal and have stable wavelengths, and the wavelength control signal is generated by calculating the first optical signal emitted by the light emitting apparatus.

In the case that the optical signal is an optical pulse signal, it is assumed that intermittent optical pulse signals are generated. The method disclosed in this embodiment generates intermittent optical pulse signals of stable wavelengths. Supposing that the system disclosed in the first embodiment is applied in the fourth embodiment, the method in the fourth embodiment includes the following steps:

Step 101: The DFB laser generates an optical pulse signal and sends it to the optical splitter.

Step 102: The optical splitter receives the optical pulse signal generated by the DFB laser, splits the optical pulse signal into two parts, sends one part of the optical pulse signal to the wavelength sensor, and sends the other part of the optical pulse signal to the acoustic-optic modulator.

Step 103: The wavelength sensor receives one part of the optical pulse signal of the DFB laser as a result of splitting by the optical splitter, and reports the wavelength value of this part of optical pulse signal to the signal processor.

Step 104: The signal processor checks for the deviation between the wavelength value of the received optical signal and the preset wavelength value; if the deviation falls within the preset deviation value range, the process proceeds to step 105; otherwise, the process proceeds to step 106.

Step 105: The system requirements are fulfilled, and no operation is required.

Step 106: According to the deviation value, the signal processor generates the corresponding wavelength control signal and sends it to the controller.

Step 107: The controller receives the wavelength control signal, controls the working parameters of the DFB laser according to the wavelength control signal, and ensures that the wavelength value of the optical pulse signals output by the DFB laser is consistent with the preset wavelength value.

The foregoing steps complete the wavelength lockout feedback operation, and can control the optical signals generated by the DFB laser to have steady wavelengths all the time.

Step 108: The pulse control signal generated by the signal processor is sent to the pulse modulation driver. The pulse modulation driver generates a pulse drive signal, which drives the DFB laser to generate an optical pulse signal.

The DFB laser generates the optical pulse signals that match the pulse drive signal continuously as driven by the pulse drive signal.

Step 109: The acoustic-optic modulator receives the other part of the optical pulse signal from the optical splitter, and outputs intermittent optical pulse signals of stable wavelengths as driven by the amplitude drive signal.

This step specifically includes the following:

When the acoustic-optic modulator needs to output the received optical pulse signal, the amplitude control signal generated by the signal processor is a low-resistance control signal.

After receiving the low-resistance control signal, the amplitude modulation driver sends an amplitude drive signal which drives the acoustic-optic modulator to adjust the insertion loss to a low-resistance state. When the acoustic-optic modulator does not need to output the received optical pulse signal, the amplitude control signal generated by the signal processor is a high-resistance control signal.

After receiving the high-resistance control signal, the amplitude modulation driver sends an amplitude drive signal which drives the acoustic-optic modulator to adjust the insertion loss to a high-resistance state. The extinction ratio of the acoustic-optic modulator is very high (generally greater than 40 dB).

Therefore, when the insertion loss is in the high-resistance state, the optical signal leaked from the acoustic-optic modulator is very weak, and fulfills the OTDR working requirements.

Further, the method disclosed in this embodiment also enables an acoustic-optic modulator to output constant optical signals of stable wavelengths. In this case, the pulse drive signal sent by the pulse modulation driver is a constant signal (such as constant current signal), and its wavelength value may be the same as or different from the wavelength value of the optical pulse drive signal which generates optical pulses, but needs to ensure implementation of the wavelength feedback control operation.

In the foregoing embodiment, the amplitude drive signal is adjusted to keep the insertion loss of the optical modulator in the low-resistance state. Therefore, the acoustic-optic modulator outputs optical pulse signals of stable wavelengths or constant optical signals of stable wavelengths. By adjusting the amplitude drive signal, the insertion loss of the acoustic-optic modulator keeps in the high-resistance state, and ensures that no optical signal is output.

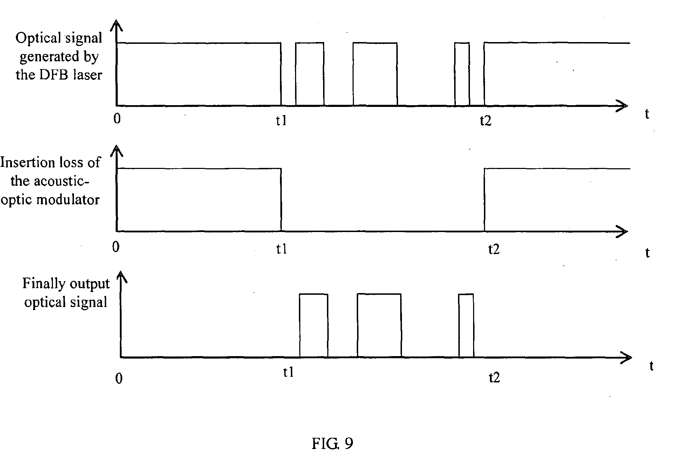

FIG. 9 shows a working time sequence of the method provided in this embodiment. The DFB laser generates optical signals of stable wavelengths in the period from 0 to t1, generates optical pulse signals of stable wavelengths in the period from t1 to t2, and resumes generating the optical signals of stable wavelengths after t2. Accordingly, the insertion loss of the acoustic-optic modulator is adjusted to the high-resistance state in the 0-t1 period, low-resistance state in the t1-t2 period, and high-resistance state after t2. Therefore, the final output of the acoustic-optic modulator is: no optical signal is output in the 0-t1 period, optical pulse signals of stable wavelengths generated by the DFB laser are output in the t1-t2 period, and no optical signal is output after t2.

Further, the acoustic-optic modulator disclosed in this embodiment may be an electrically variable attenuator or another amplitude modulator.

The optical modulation method disclosed in this embodiment controls stable wavelengths by using a part of the optical pulse signal of the DFB laser as a result of splitting by the optical splitter, and finally generates intermittent optical pulse signals of stable wavelengths under collaborative work of the components such as pulse modulation driver and amplitude modulation driver. The generated signals meet the requirements imposed on the signals transmitted by the transmitter in the detection systems such as OTDR, and meet the application requirements imposed by the monitoring systems deployed through optical cables and marine cables.

### Embodiment 5

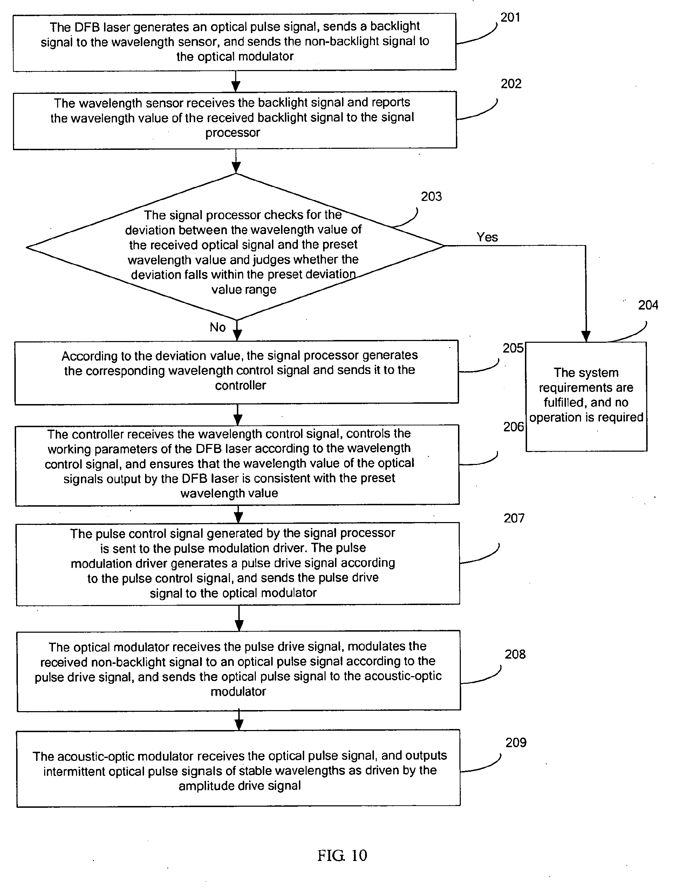

As shown in FIG. 10, an optical modulation method is disclosed in this embodiment. The method disclosed in this embodiment generates intermittent optical pulses of stable wavelengths. Supposing that the system disclosed in the third embodiment is applied in the fifth embodiment, the method disclosed in the fifth embodiment includes the following steps:

Step 201: The DFB laser generates an optical signal, sends a backlight signal to the wavelength sensor, and sends the non-backlight signal to the optical modulator.

Step 202: The wavelength sensor receives the backlight signal and reports the wavelength value of the received backlight signal to the signal processor.

Step 203: The signal processor checks for the deviation between the wavelength value of the received optical signal and the preset wavelength value; if the deviation falls within the preset deviation value range, the process proceeds to step 204; otherwise, the process proceeds to step 205.

Step 204: The system requirements are fulfilled, and no operation is required.

Step 205: According to the deviation value, the signal processor generates the corresponding wavelength control signal and sends it to the controller.

Step 206: The controller receives the wavelength control signal, controls the working parameters of the DFB laser according to the wavelength control signal, and ensures that the wavelength value of the optical signals output by the DFB laser is consistent with the preset wavelength value.

Step 207: The pulse control signal generated by the signal processor is sent to the pulse modulation driver. The pulse modulation driver generates a pulse drive signal according to the pulse control signal, and sends the pulse drive signal to the optical modulator.

Step 208: The optical modulator receives the pulse drive signal, modulates the received non-backlight signal to an optical pulse signal according to the pulse drive signal, and sends the optical pulse signal to the acoustic-optic modulator.

Step 209: The acoustic-optic modulator receives the optical pulse signal, and outputs intermittent optical pulse signals of stable wavelengths as driven by the amplitude drive signal.

The optical modulation method disclosed in this embodiment controls stable wavelengths by using the backlight signal of the DFB laser, and finally generates intermittent optical pulse signals of stable wavelengths under collaborative work of the components such as optical modulator, pulse modulation driver and amplitude modulation driver. The generated signals meet the requirements imposed on the signals transmitted by the transmitter in the detection systems such as OTDR, and meet the application requirements imposed by the monitoring systems deployed through optical cables and marine cables.

The technical solution disclosed in the foregoing embodiment controls stable wavelengths by using a wavelength sensor, generates optical signals of stable wavelengths, and generates intermittent optical pulse signals of stable wavelengths under collaborative work of the components such as pulse modulation driver and amplitude modulation driver. The generated signals meet the requirements imposed on the signals transmitted by the transmitter in the detection systems such as OTDR, and meet the application requirements imposed by the monitoring systems deployed through optical cables.

The technical solution under the present invention also solves the returning of the backscattering optical signals of fault-probing optical signals (specifically, optical pulse signals) in marine cable communication. In a marine cable monitoring system, the backscattering optical signals are coupled to another reverse transmission link in the trunk of the Erbium-doped optical power amplifier. The reverse transmission fiber of the reverse transmission link serves as a return path of the backscattering optical signals to monitor the marine fibers. Therefore, through the technical solution disclosed herein, the wavelengths of the probing optical signals can be stabilized within the amplification range of the Erbium-doped optical power amplifier, and can be further stabilized to fluctuate within less than a nanometer, thus avoiding impact on the service signals and ensuring that the wavelengths of the probing optical signals fall within the filtering range of the optical filter at the receiver.

All or part of the steps of the foregoing embodiments may be implemented by a software program. The program may be stored in a computer-readable storage medium such as compact disk and hard disk.

Although the invention has been described through some exemplary embodiments, the invention is not limited to such embodiments. It is apparent that those skilled in the art can make various modifications and variations to the invention without departing from the spirit and scope of the invention. The invention is intended to cover the modifications and variations provided that they fall in the scope of protection defined by the following claims or their equivalents.

## Claims

1. An optical modulation system, comprising:
a light emitting apparatus 301, adapted to generate optical signals;
a wavelength sensor 302, adapted to: receive a first optical signal among the optical signals generated by the light emitting apparatus 301, and report a wavelength value of the first optical signal;
a signal processor 303, adapted to: receive the wavelength value reported by the wavelength sensor 302, calculate deviation between the wavelength value and a preset wavelength value, generate a wavelength control signal according to the deviation, and send the wavelength control signal;
a controller 304, adapted to: receive the wavelength control signal from the signal processor 303, and adjust working parameters of the light emitting apparatus 301 according to the wavelength control signal;
an amplitude modulation driver 306, adapted to generate and send an amplitude drive signal; and
an amplitude modulator 307, adapted to: receive a second optical signal generated by the light emitting apparatus 301 and the amplitude drive signal sent by the amplitude modulation driver 306, modulate the second optical signal according to the amplitude drive signal, and output intermittent optical signals of stable wavelengths.

2. The optical modulation system of claim 1, further comprising:
an optical splitter 308, adapted to split the optical signal generated by the light emitting apparatus 301;
wherein, accordingly, the wavelength sensor 302 is adapted to: receive the first optical signal as a result of splitting by the optical splitter 308, and report the wavelength value of the first optical signal to the signal processor 303; and
the amplitude modulator 307 is adapted to: receive the second optical signal as a result of splitting by the optical splitter 308 and the amplitude drive signal sent by the amplitude modulation driver 306, modulate the second optical signal according to the amplitude drive signal, and output the intermittent optical signals of the stable wavelengths.

3. The optical modulation system of claim 1, wherein:
the first optical signal received by the wavelength sensor 302 from the light emitting apparatus 301 is a backlight signal generated by the light emitting apparatus; and
accordingly, the second optical signal received by the amplitude modulator 307 from the light emitting apparatus 301 is a non-backlight signal generated by the light emitting apparatus.

4. The optical modulation system according to any one of claims 1-3, further comprising:
a pulse modulation driver 305, adapted to: generate a pulse drive signal, and drive the light emitting apparatus 301 with the pulse drive signal, wherein:
the light emitting apparatus 301 generates optical pulse signals as driven by the pulse modulation driver 305.

5. The optical modulation system of claim 4, wherein the light emitting apparatus 391 comprises a laser 3011 and an optical modulator 3012, and the laser 3011 is adapted to generate the optical signals;
accordingly,
the controller 304 is adapted to: receive the wavelength control signal from the signal processor 303, and adjust working parameters of the laser 3011 according to the wavelength control signal;
the pulse modulation driver 305 is adapted to: generate a pulse drive signal, and drive the optical modulator 3012 with the pulse drive signal; and
the optical modulator 3012 is adapted to: receive the pulse drive signal, modulate the laser 3011 to generate the optical signal according to the pulse drive signal, and output the optical pulse signal.

6. The optical modulation system of claim 5, wherein the optical modulator 3012 is:
an acousto-optic modulator, an electroabsorption modulator, or a waveguide modulator.

7. The optical modulation system of claim 4, wherein:
the signal processor 303 further comprises a pulse control signal generating module 3031, which is adapted to generate a pulse control signal, and send the pulse control signal to the pulse modulation driver 305;
accordingly, the pulse modulation driver 305 is adapted to generate the pulse drive signal according to the pulse control signal sent by the pulse control signal generating module 3031;
the signal processor 303 further comprises an amplitude control signal generating module 3032, which is adapted to generate an amplitude control signal, and send the amplitude control signal to the amplitude modulation driver 306;
accordingly, the amplitude modulation driver 306 is adapted to: generate the amplitude drive signal according to the amplitude control signal sent by the amplitude control signal generating module 3032, and send the amplitude drive signal to the amplitude modulator 307.

8. The optical modulation system of claim 1, wherein:
the amplitude modulator 307 is an acousto-optic modulator or an electrically variable attenuator.

9. An optical modulation method, comprising:
receiving a second optical signal among optical signals generated by a light emitting apparatus, and outputting intermittent optical signals of stable wavelengths under modulation of an amplitude drive signal, wherein: the optical signals are generated by the light emitting apparatus under control of a wavelength control signal and have stable wavelengths, and the wavelength control signal is generated by calculating a first optical signal emitted by the light emitting apparatus.

10. The optical modulation method of claim 9, wherein:
the optical signals are optical pulse signals, and the optical pulse signals are generated by the light emitting apparatus under control of the wavelength control signal and a pulse drive signal and have stable wavelengths.

11. The optical modulation method of claim 10, wherein the generating, by the light emitting apparatus, of the optical pulse signals of stable wavelengths under control of the wavelength control signal and the pulse drive signal comprises:
generating, by a signal processor, the wavelength control signal and a pulse control signal, and sending the wavelength control signal to a controller and sending the pulse control signal to a pulse modulation driver;
receiving, by the controller, the wavelength control signal, and controlling working parameters of the light emitting apparatus according to the wavelength control signal;
receiving, by the pulse modulation driver, the pulse control signal, generating the pulse drive signal according to the pulse control signal, and sending the pulse drive signal to the light emitting apparatus; and
generating, by the light emitting apparatus, the optical pulse signals of the stable wavelengths under control of the wavelength control signal and the pulse drive signal.

12. The optical modulation method of claim 10, wherein:
the light emitting apparatus comprises a laser and an optical modulator;
accordingly, the generating, by the light emitting apparatus, of the optical pulse signals of the stable wavelengths under control of the wavelength control signal and the pulse drive signal comprises:
generating, by a signal processor, the wavelength control signal and a pulse control signal, and sending the wavelength control signal to a controller and sending the pulse control signal to a pulse modulation driver;
receiving, by the controller, the wavelength control signal, and controlling working parameters of the laser according to the wavelength control signal;
receiving, by the pulse modulation driver, the pulse control signal, generating the pulse drive signal according to the pulse control signal, and sending the pulse drive signal to the optical modulator;
generating, by the laser, the optical signals of the stable wavelengths under control of the wavelength control signal, and sending the optical signals of the stable wavelengths to the optical modulator; and
generating, by the optical modulator, the optical pulse signals of the stable wavelengths under control of the pulse drive signal after receiving the optical signals of the stable wavelengths.

13. The optical modulation method of claim 10, wherein:
the receiving a second optical pulse signal among optical signals generated by a light emitting apparatus, and outputting intermittent optical pulse signals of stable wavelengths under modulation of an amplitude drive signal, comprise:
generating, by the signal processor, the amplitude control signal, and sending the amplitude control signal to the amplitude modulation driver;
receiving, by the amplitude modulation driver, the amplitude control signal, generating the amplitude drive signal according to the amplitude control signal, and sending the amplitude drive signal to the amplitude modulator; and
receiving, by the amplitude modulator, the second optical pulse signal emitted by the light emitting apparatus, and outputting the intermittent optical pulse signals of stable wavelengths as driven by the amplitude drive signal.
